# EUROPEAN PATENT APPLICATION

(11) **EP 4 756 711 A1**
(43) Date of publication of application: **10.06.2026**
(21) Application number: 25837553.4
(22) Date of filing: 18.06.2025
(51) Int. Cl.: G06T 7/00, G06V 10/774, G06N 20/00, G01R 31/385

(54) **DIAGNOSTIC SYSTEM USING ARTIFICIAL INTELLIGENCE MODEL AND OPERATION METHOD THEREOF**

(30) Priority: 10.07.2024 KR 20240090819
(71) Applicant: LG Energy Solution, Ltd., Seoul 07335 (KR)
(72) Inventor: KIM, Jongwoo, Daejeon 34122 (KR)
(74) Representative: Goddar, Heinz J.
(86) International application number: PCT/KR2025/008373
(87) International publication number: WO 2026/014749

(57) **Abstract**

A diagnostic system according to one embodiment of the present invention may comprise: a first device for training a machine learning-based diagnostic model by using a training image; and a second device for determining whether an object to be diagnosed is defective by using the diagnostic model provided from the first device and an inference image of the object to be diagnosed. Here, the second device may determine whether the inference image is a retraining target on the basis of whether a predefined condition is satisfied, and the first device may store, in a predefined storage space, the original of the inference image determined as the retraining target by the second device.

## Description

### [Technical Field]

This application claims priority to and the benefit of Korean Patent Application No.10-2024-0090819 filed in the Korean Intellectual Property Office on July 10, 2024 the entire contents of which are incorporated herein by reference.

The present invention relates to a diagnostic method for detecting abnormality, a diagnostic system, and an operation method thereof, and more specifically, to a diagnostic system that diagnoses a diagnostic target using an artificial intelligence-based diagnostic model, and an operation method thereof.

### [Background Art]

Secondary batteries, capable of recharging and reuse, may be used as an energy source for small devices such as mobile phones, tablet PCs and vacuum cleaners, and also used as an energy source for medium and large devices such as personal mobility, automobiles and an energy storage system (ESS) for smart grids.

Secondary batteries are used in the form of assemblies, such as battery modules, in which multiple battery cells are connected in series and parallel, or battery packs, in which battery modules are connected in series and parallel, depending on the system requirements.

Manufacturing battery cells or battery assemblies requires various processes. Automated equipment may be installed on a production line to perform each process, and seamless connection of these automated equipment enables mass production of battery cells or battery assemblies.

To ensure product quality meets required standards, diagnostics are performed at key processing points on the production line. Typically, a video-based monitoring system (FMVS; Factory Monitoring Visual System) using cameras installed at key processing points on the production line may be utilized.

Recently, an FMVS that utilizes an artificial intelligence (AI) model has been proposed to improve the diagnostic accuracy of monitoring systems. These diagnostic systems input images of a target for diagnosis into an AI-based diagnostic model and determine whether the target is defective based on results output by the diagnostic model.

To further improve the diagnostic accuracy of these diagnostic systems, updating the diagnostic model is necessary. Here, updating the diagnostic model may be accomplished by retraining the diagnostic model using original images used in the diagnostic process as training data.

However, since the original images collected during the diagnostic process are high-resolution, high-volume data, building a repository to store these massive amounts of original images requires significant costs.

Among the prior art documents relevant to the present invention, KR 10-2018-0009563 A is of some relevance.

### [Detailed Description of the Invention]

### [Technical Problem]

To obviate one or more problems of the related art, embodiments of the present disclosure provide a diagnostic system using an artificial intelligence (AI) model.

To obviate one or more problems of the related art, embodiments of the present disclosure also provide an operation method of the diagnostic system.

### [Technical Solution]

In order to achieve the objective of the present disclosure, a diagnostic system may include a first device configured to train a machine learning-based diagnostic model using training images; and a second device configured to determine whether a diagnostic target is defective using the diagnostic model provided from the first device and an inference image of the diagnostic target. Here, the second device may determine whether the inference image is a target for retraining based on whether one or more predefined conditions are satisfied, and the first device may store the original of the inference image which has been determined by the second device to be a target for retraining, in a predefined storage space.

The first device may compress an inference image determined not to be a target for retraining according to a predefined image processing process and store the compressed image of the inference image separately from the original of the inference image.

The first device includes a storage device that stores the inference image. Here, the storage device may include a first storage space that stores a first image, which is the original of the inference image; and a second storage space that stores a second image, which is a converted image of the original, having a lower capacity or quality.

The first device may retrain the diagnostic model using a plurality of first images stored in the first storage space as training data.

The first device may reconstruct at least some of the second images stored in the second storage space according to a predefined image processing process and retrains the diagnostic model using the reconstructed images.

The first device may convert a first image for which a preset storage period has elapsed, among a plurality of first images stored in the first storage space, into a second image and stores the second image in the second storage space.

The second device may determine the inference image as a target for retraining if both conditions are satisfied, the conditions including a first condition, in which the inference image is determined to be defective by the diagnostic model; and a second condition, in which the inference image is determined to be defective by a defect detection model defined separately from the diagnostic model.

The second device may determine the inference image as a target for retraining if a third condition, in which an abnormal area is detected by an anomaly detection model defined separately from the diagnostic model and the defect detection model, is satisfied, even if the first condition is not satisfied.

According to another embodiment of the present disclosure, an operation method of a diagnostic system, including a first device configured to train a machine learning-based diagnostic model using training images; and a second device configured to determine whether a diagnostic target is defective using the diagnostic model provided from the first device and an inference image of the diagnostic target, may include determining, by the second device, whether the inference image is a target for retraining based on whether one or more predefined conditions are satisfied; and storing, by the first device, the original of the inference image which has been determined by the second device to be a target for retraining, in a predefined storage space.

The operation method of the diagnostic system may further include compressing, by the first device, an inference image determined not to be a target for retraining according to a predefined image processing process; and storing, by the first device, the compressed image of the inference image separately from the original of the inference image.

The first device may include a storage device that stores the inference image, and the storage device may include a first storage space that stores a first image, which is the original of the inference image; and a second storage space that stores a second image, which is a converted image of the original, having a lower capacity or quality.

The operation method of the diagnostic system may further include retraining, by the first device, the diagnostic model using a plurality of first images stored in the first storage space as training data.

The operation method of the diagnostic system may further include reconstructing, by the first device, at least some of the second images stored in the second storage space according to a predefined image processing process; and retraining, by the first device, the diagnostic model using the reconstructed images.

The operation method of the diagnostic system may further include converting, by the first device, a first image for which a preset storage period has elapsed, among a plurality of first images stored in the first storage space, into a second image and storing the second image in the second storage space.

The determining of whether the inference image is a target for retraining may include determining the inference image as a target for retraining if both conditions are satisfied, the conditions including a first condition, in which the inference image is determined to be defective by the diagnostic model; and a second condition, in which the inference image is determined to be defective by a defect detection model defined separately from the diagnostic model.

The determining of whether the inference image is a target for retraining may include determining the inference image as a target for retraining if a third condition, in which an abnormal area is detected by an anomaly detection model defined separately from the diagnostic model and the defect detection model, is satisfied, even if the first condition is not satisfied.

### [Advantageous Effects]

According to embodiments of the present disclosure, diagnostic accuracy of the diagnostic system can be improved and the cost of constructing a storage device included in the diagnostic system can be minimized.

### [Brief Description of the Drawings]

FIG. 1 is a block diagram of a factory monitoring system according to embodiments of the present invention.
FIG. 2 is a block diagram of a diagnostic system according to embodiments of the present invention.
FIG. 3 is a flowchart illustrating a method for operating a diagnostic system using a second device according to an embodiment of the present invention.
FIG. 4 is a flowchart illustrating a method for operating a diagnostic system using the second device according to another embodiment of the present invention.
FIG. 5 is a flowchart illustrating a method for operating a diagnostic system using a first device according to an embodiment of the present invention.
FIG. 6 is a flowchart illustrating a method for operating a diagnostic system using the first device according to another embodiment of the present invention.
FIG. 7 is a block diagram of the first device according to embodiments of the present invention.
FIG. 8 is a block diagram of a second device according to embodiments of the present invention.
   10: diagnostic target
   20: image Sensor
   30: diagnostic apparatus
   40: diagnostic model training apparatus
   100, 700: first Device
   200, 800: second Device

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Hereinafter, various embodiments of the present invention will be described in detail with reference to the attached drawings. Meanwhile, the description will exemplify that a diagnostic system according to the present invention installed in a battery production or assembly factory to diagnose batteries or battery processing equipment. However, the scope of the present invention is not limited to such inspection targets.

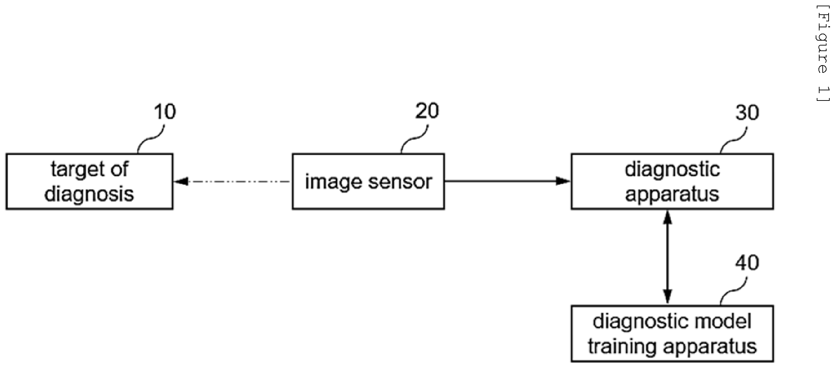

FIG. 1 is a block diagram of a factory monitoring system according to embodiments of the present invention.

Referring to FIG. 1, the factory monitoring system according to embodiments of the present invention may include an image sensor 20, a diagnostic apparatus 30, and a diagnostic model learning apparatus 40.

The image sensor 20 is a device that generates image data for one or more diagnostic targets 10 located within a factory. For example, the image sensor 20 may correspond to a camera fixed to a specific location.

The image sensor 20 may be connected to the diagnostic apparatus 30 via a network and transmit image data for the diagnostic target 10 to the diagnostic apparatus 30.

The image sensor 20 may generate image data for a specific area of the diagnostic target 10. For example, the image sensor 20 may be installed at a specific location in the assembly facility and configured to capture a fastening area of a specific bolt. For another example, the image sensor 20 may be installed near an electrolyte injection device and configured to capture the interior of the electrolyte injection device.

The image sensor 20 may generate image data for the diagnostic target 10 at preset time intervals and transmit the image data to the diagnostic apparatus 30. For example, the image sensor 20 may generate 60 image data per second (60 frames per second) and transmit the image data to the diagnostic apparatus 30.

The factory monitoring system may include a plurality of image sensors 20. Each image sensor may be positioned at a preset location, generate image data for its corresponding diagnostic target, and transmit the generated image data to the diagnostic apparatus 30.

The diagnostic apparatus 30 may receive image data from the image sensor 20 and diagnose whether the diagnostic target has an abnormality based on the image data. Here, the diagnostic apparatus 30 for detecting abnormality may determine whether the diagnostic target has a defect using the image data received from the image sensor 20 and a predefined diagnostic model. For example, the diagnostic apparatus 30 may determine whether there are defects such as bolt fastening failures, cell assembly failures, or cell specification failures.

The diagnostic model learning apparatus 40 may be a computing device that generates a diagnostic model and provides the diagnostic model to the diagnostic apparatus 30. Here, the diagnostic model learning apparatus 40 may train a machine learning-based diagnostic model using learning data and provide the trained diagnostic model to the diagnostic apparatus 30.

The diagnostic apparatus 30 may input one or more images of the diagnostic target transmitted from the image sensor into the diagnostic model provided by the diagnostic model learning apparatus 40 and determine whether the diagnostic target has a defect based on inference results output by the diagnostic model. In other words, the diagnostic apparatus 30 may perform a diagnosis on a diagnostic target using an inference image received from the image sensor 20 and the trained diagnostic model provided by the diagnostic model learning apparatus 40.

The diagnostic model learning apparatus 40 may store inference images in a storage device. Here, the diagnostic model learning apparatus 40 may store the original of the inference image and a compressed image of the inference image separately in the storage device.

The diagnostic model learning apparatus 40 may retrain the diagnostic model after a preset period of time has elapsed or at a user request. Here, the diagnostic model learning apparatus 40 may retrain the diagnostic model using the image stored in the storage device. Upon completion of the retraining, the diagnostic model learning apparatus 40 may provide the retrained diagnostic model to the diagnostic apparatus 30.

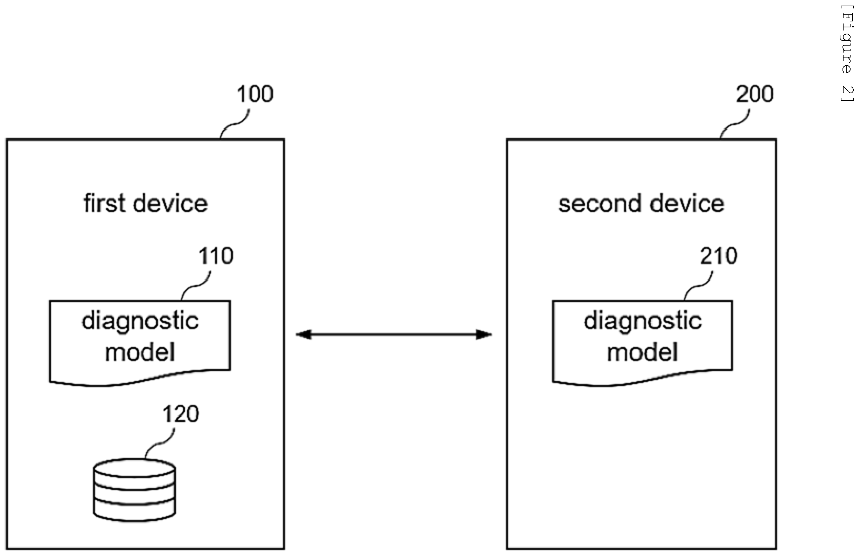

FIG. 2 is a block diagram of a diagnostic system according to embodiments of the present invention.

Referring to FIG. 2, the diagnostic system according to embodiments of the present invention may include a first device 100 and a second device 200. Here, the first device 100 may correspond to the diagnostic model learning apparatus 40 of FIG. 1 and the second device 200 may correspond to the diagnostic apparatus 30 of FIG. 1.

The first device 100 may train a machine learning-based diagnostic model 110 for diagnosing a diagnostic target and provide the trained diagnostic model to the second device 200.

The diagnostic model 110 may be trained to output whether a diagnostic target is defective (normal or defective) as output data upon receiving the image of the diagnostic target as input data.

The first device 100 may include a storage device 120 where training images are stored and train the diagnostic model 110 using the training images stored in the storage device 120.

The second device 200 may use the diagnostic model 210 received from the first device 100 and an inference image of the diagnostic target to determine whether the diagnostic target is defective. For example, the second device 200 may receive an image of the diagnostic target generated by an image sensor as an inference image and input the inference image into the diagnostic model 210. Here, the second device 200 may determine whether the diagnostic target is defective based on the inference result output by the diagnostic model 210.

The second device 200 may determine whether the inference image is a target for retraining based on whether a predefined condition is satisfied.

For example, if the inference result of the diagnostic model 210 is [Faulty], the second device 200 may determine the corresponding inference image as a target for retraining.

For another example, if the inference result of the diagnostic model 210 is [Faulty] and the inference result of a machine learning-based defect detection model, which is separately defined from the diagnostic model, is also [Faulty], the second device 200 may determine the corresponding inference image as a target for retraining.

For yet another example, even if the inference result of the diagnostic model 210 is [Normal], if the inference result of a machine learning-based anomaly detection model defined separately from the diagnostic model is [Abnormal Area Detection], the second device 200 may determine the corresponding inference image as a target for retraining.

The first device 100 may store the inference image in the storage device 120. Here, the first device 100 may receive the inference image from the second device 200 or from an image sensor.

The first device 100 may store the inference image in its original form in the storage device 120, or may convert the inference image into a low-capacity or low-quality image using a predefined image processing process and then store the converted image in the storage device 120.

Here, if a specific inference image is determined by the second device 200 to be a retraining target, the first device 100 may store the original inference image in the storage device. Furthermore, if the second device 200 determines that a specific inference image is not a retraining target, the first device 100 may compress the inference image using a predefined image processing process and store the compressed inference image in the storage device.

The storage device 120 of the first device 100 may include a first storage space for storing a first image, which is the original of the inference image, and a second storage space for storing a second image, which is a converted image of the original inference image with a lower capacity or quality.

For example, the first device 100 may store the original inference image (e.g., a BMP file) determined to be a retraining target in the first storage space of the storage device 120. In another example, the first device 100 may compress an inference image determined not to be a retraining target using a predefined compression process and store the compressed image (e.g., a JPEG file) in the second storage space. In other words, the first device may classify inference images and separately store them based on whether they are retraining targets, and thus, images that are retraining targets may be stored as originals, while images that are not retraining targets may be converted to lower capacity and stored.

The first device 100 may convert first images stored in the first storage space, for which a preset storage period has elapsed, into second images and then store them in the second storage space. For example, the first device 100 may select images for which a storage period of more than one year has elapsed from among the original images stored in the first storage space, compress the selected original images, and then move them to the second storage space.

The first device 100 may retrain the diagnostic model 110 using the images stored in the storage device 120. Here, the first device 100 may retrain the diagnostic model 110 using the first images stored in the first storage space of the storage device 120 as training data.

The first device 100 may restore at least some of the second images stored in the second storage space of the storage device 120 according to a predefined image processing process, and use the restored images as training data to retrain the diagnostic model 110. For example, the first device 100 may select one or more second images from among the second images stored in the second storage space based on conditions set by a user (e.g., images stored for a specific period of time or images determined to have a specific defect type). Thereafter, the first device 100 may restore the selected second images into high-resolution or high-quality images using a predefined image restoration algorithm, and then retrain the diagnostic model 110 using the restored images.

In other words, the diagnostic system according to embodiments of the present invention may classify inference images, input during a diagnostic process, into retraining targets and non-retraining targets, store the retraining target images as originals, and utilize them in a subsequent retraining process of the diagnostic model. Furthermore, the diagnostic system may compress and store images which are not targets for retraining, select a subset of these compressed images needed for retraining, restore them, and utilize them in a retraining process. This minimizes the cost of building storage within the diagnostic system, while also preventing degradation in the quality of training data for retraining the diagnostic model.

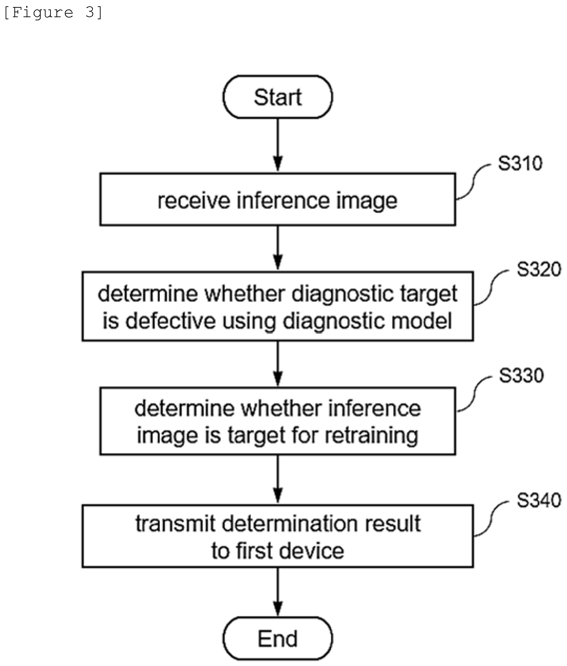

FIG. 3 is a flowchart illustrating a method for operating a diagnostic system by a second device according to an embodiment of the present invention.

The second device may receive an inference image generated by an image sensor (S310).

Thereafter, the second device may input the inference image into the diagnostic model received from the first device and determine whether the diagnostic target is defective based on the inference results output by the diagnostic model (S320).

The second device may determine whether the inference image is a target for retraining based on whether predefined conditions are satisfied (S330).

In embodiments, the second device may determine the inference image as a target for retraining if both a first condition, in which the inference image is determined to be defective by the diagnostic model, and a second condition, in which the inference image is determined to be defective by a defect detection model defined separately from the diagnostic model, are satisfied.

The second device may receive a defect detection model that has been trained from the first device. Here, the defect detection model may be a machine learning-based model pre-trained using inference images determined to be defective as training data. For example, the defect detection model may be defined to learn features extracted from images determined to be defective and output whether or not an inference image is defective upon input of the inference image.

In other words, according to embodiments of the present embodiment, if an inference image is determined to be defective by the diagnostic model applied to the second device and also determined to be defective by the defect detection model provided separately from the diagnostic model, the inference image may be determined to be a target image for retraining.

In another embodiment, the second device may determine the inference image as a target for retraining, even if the first condition is not satisfied, when the third condition, in which an abnormal area is detected by an anomaly detection model defined separately from the diagnostic model and the defect detection model, is satisfied.

The second device may receive a trained anomaly detection model from the first device. Here, the anomaly detection model may be a machine learning-based model pre-trained to determine whether an input image contains a pre-defined abnormal area.

In other words, according to the present embodiment, the inference image may be determined to be an image for retraining, even if the inference image is determined to be normal by the diagnostic model applied to the second device, if it is determined to contain an abnormal region by an anomaly detection model provided separately from the diagnostic model.

The second device may transmit the determination result in step S330 to the first device (step S340). Here, the second device may transmit the originals of the inference image along with the determination result for the inference image to the first device.

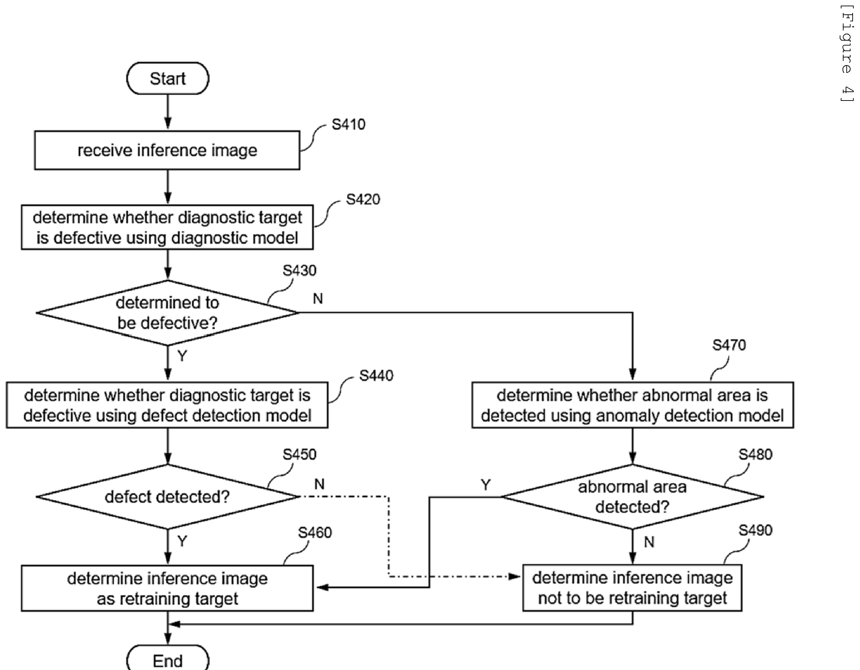

FIG. 4 is a flowchart illustrating a method for operating a diagnostic system by the second device according to another embodiment of the present invention.

The second device may receive an inference image generated by an image sensor (S410).

Thereafter, the second device may use the inference image and a diagnostic model received from the first device to determine whether the diagnostic target is defective (S420).

If it is determined by the diagnostic model that the diagnostic target is defective (Y in S430), the second device may input the inference image into a defect detection model defined separately from the diagnostic model and determine whether the target is defective based on the inference results output by the defect detection model (S440).

If the defect detection model detects a defect in the diagnostic target (Y in S450), the second device may determine the corresponding inference image as a retraining target (S460). If the defect detection model does not detect a defect in the diagnostic target (N in S450), the second device may determine the inference image as not subject to retraining (S490).

If it is determined by the diagnostic model that the diagnostic target is normal (N in S430), the second device may input the inference image into an anomaly detection model defined separately from the diagnosis model and determine whether an abnormal area is detected in the diagnostic target based on the inference results output by the anomaly detection model (S470).

If an abnormal area is detected in the diagnostic target by the anomaly detection model (Y in S480), the second device may determine the inference image as a target for retraining (S460). If the anomaly detection model does not detect an abnormal area in the diagnostic target (N in S480), the second device may determine the inference image as not subject to retraining (S490).

The second device may transmit the determination result for the inference image to the first device (S340). Here, the second device may transmit the originals of the inference image, along with the determination results for the inference image, to the first device.

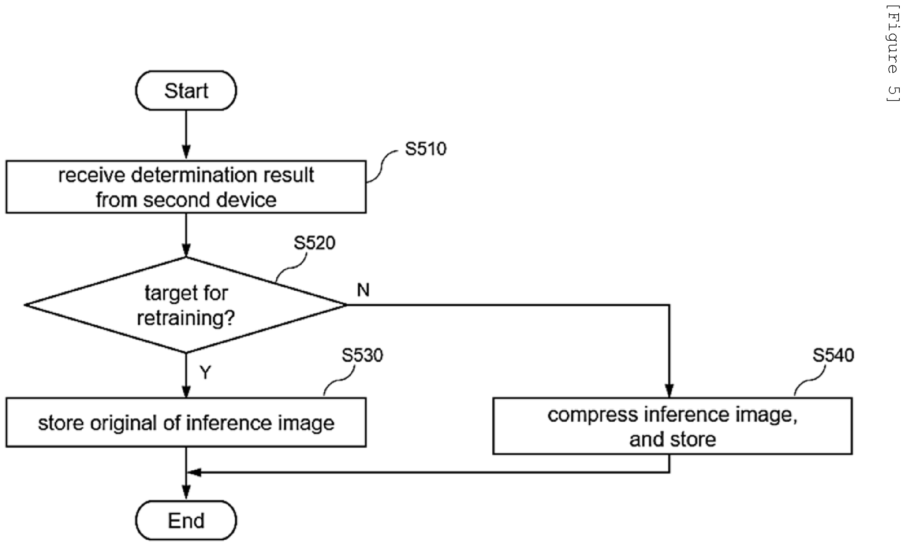

FIG. 5 is a flowchart illustrating a method for operating a diagnostic system by a first device according to an embodiment of the present invention.

The first device may receive an original inference image and a determination result including whether the inference image is subject to retraining, from the second device (S510).

If the inference image is subject to retraining (Y in S520), the first device may store the original of the inference image in a storage device (S530). Here, the first device may store the original (e.g., a BMP file) of the inference image determined to be subject to retraining in a first storage space of the storage device.

If the inference image is not subject to retraining (N in S520), the first device may convert the inference image to a low-capacity or low-quality image using a predefined image processing process and store the converted inference image in the storage device (S540). Here, the first device may compress inference images determined not to be retrained using a predefined compression process and store the compressed images (e.g., JPEG files) in a second storage space of the storage device.

In other words, the first device may classify and store inference images separately based on whether they are to be retrained or not. Images subject to retraining may be stored in their original form, while images not subject to retraining may be converted to a lower capacity and stored.

The first device may compress images, among the original images stored in the first storage space, that have exceeded a preset storage period, and then move the compressed images to the second storage space.

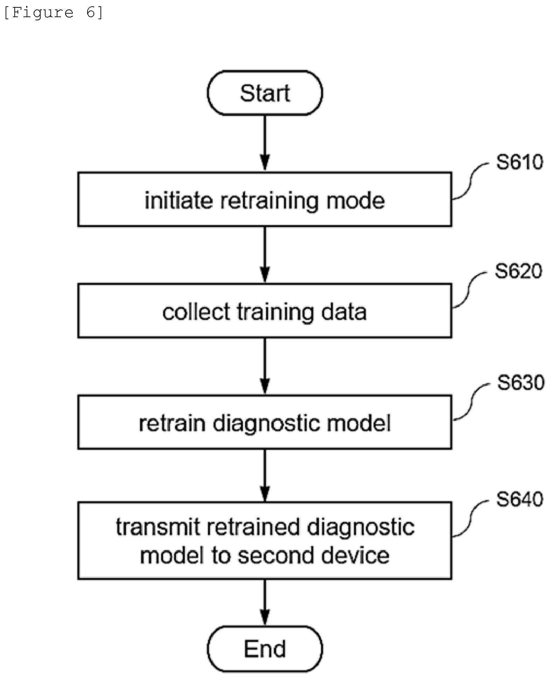

FIG. 6 is a flowchart illustrating a method for operating a diagnostic system by the first device according to another embodiment of the present invention.

The first device may initiate a mode for retraining a diagnostic model when a preset period of time has elapsed or a user request corresponding to initiation of a retraining mode is received (S610).

Once the retraining mode is initiated, the first device may collect training data from a storage device (S620).

According to an embodiment, the first device may determine the original images stored in the first storage space of the storage device as training data.

In another embodiment, the first device may restore at least some of compressed images stored in the second storage space of the storage device according to a predefined image processing process and determine the restored images as training data.

Thereafter, the first device may retrain a prestored diagnostic model using the training data collected in S620 (S630).

Once the retraining is completed, the first device may provide the retrained diagnostic model to the second device (S640). Thereafter, the second device may update the existing diagnostic model with the retrained diagnostic model and use the updated diagnostic model to determine whether the diagnostic target is defective.

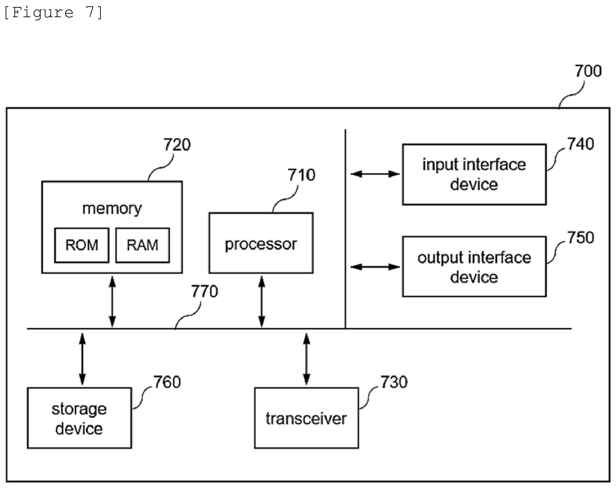

FIG. 7 is a block diagram of the first device according to embodiments of the present invention.

The first device 700 according to embodiments of the present invention may correspond to a diagnostic model learning apparatus of a factory monitoring system or may be implemented as included in a diagnostic model learning apparatus.

The first device 700 may include at least one processor 710, a memory 720 that stores at least one instruction executed by the processor, and a transceiver 730 that is connected to a network and performs communication.

The at least one instruction may include an instruction to store the original of the inference image which has been determined by a second device to be a target for retraining, in a predefined storage space.

The at least one instruction may further include an instruction to compress an inference image determined not to be a target for retraining according to a predefined image processing process and an instruction to store the compressed image of the inference image separately from the original of the inference image.

The at least one instruction may further include an instruction to retrain the diagnostic model using a plurality of first images stored in the first storage space as training data.

The at least one instruction may further include an instruction to reconstruct at least some of the second images stored in the second storage space according to a predefined image processing process and an instruction to retrain the diagnostic model using the reconstructed images.

The at least one instruction may further include an instruction to convert a first image for which a preset storage period has elapsed, among a plurality of first images stored in the first storage space, into a second image and an instruction to store the second image in the second storage space.

The first device 700 according to embodiments of the present invention may further include an input interface device 740, an output interface device 750, a storage device 760, etc. Respective components included in the first device 700 may be connected by a bus 770 and communicate with each other. The storage device 760 may store a diagnostic model, a defect detection model, and an anomaly detection model, and may include a first storage space for storing first images, and a second storage space for storing second images.

Here, the processor 710 may mean a central processing unit (CPU), a graphics processing unit (GPU), or a dedicated processor on which methods according to embodiments of the present invention are performed. The memory (or storage unit) may include at least one of a volatile storage medium and a non-volatile storage medium. For example, the memory may include at least one of read only memory (ROM) and random access memory (RAM).

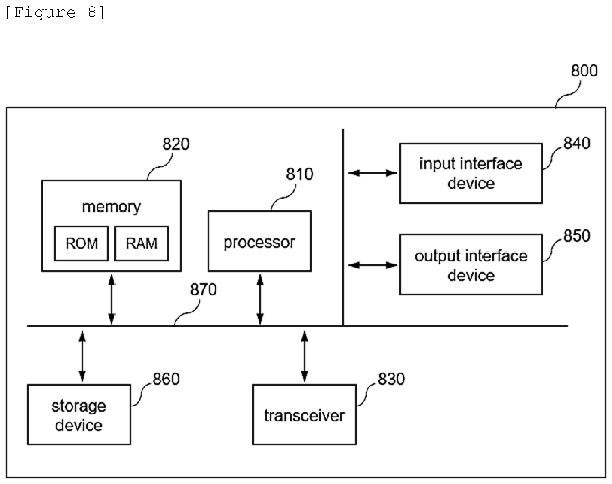

FIG. 8 is a block diagram of a second device according to embodiments of the present invention.

The second device 800 according to embodiments of the present invention may correspond to a diagnostic apparatus of a factory monitoring system or may be implemented as included in a diagnostic apparatus.

The second device 800 may include at least one processor 810, a memory 820 storing at least one instruction executed by the processor, and a transceiver 830 connected to a network to perform communication.

The at least one instruction may include an instruction to, upon receiving an inference image of a diagnostic target, determine whether the diagnostic target is defective using a diagnostic model transmitted from the first device and the inference image for the diagnostic target; an instruction to determine whether the inference image is subject to retraining based on whether predefined conditions are satisfied; and an instruction to transmit determination result to the first device.

The instruction to determine whether the inference image is subject to retraining may include an instruction to determine the inference image as a target for retraining if both a first condition, where the inference image is determined to be defective by the diagnostic model, and a second condition, where the inference image is determined to be defective by a defect detection model defined separately from the diagnostic model, are satisfied.

The instruction to determine whether the inference image is subject to retraining may include an instruction to determine the inference image as a target for retraining if a third condition, in which an abnormal area is detected by an anomaly detection model defined separately from the diagnostic model and the defect detection model, is satisfied, even if the first condition is not satisfied.

The second device 800 according to embodiments of the present invention may further include an input interface device 840, an output interface device 850, a storage device 860, etc. Respective components included in the second device 800 may be connected by a bus 870 and communicate with each other. The storage device 860 may store a diagnostic model, a defect detection model, and an anomaly detection model.

Here, the processor 810 may mean a central processing unit (CPU), a graphics processing unit (GPU), or a dedicated processor on which methods according to embodiments of the present invention are performed. The memory (or storage unit) may include at least one of a volatile storage medium and a non-volatile storage medium. For example, the memory may include at least one of read only memory (ROM) and random access memory (RAM).

The operations of the method according to the embodiments of the present invention may be implemented as a computer-readable program or code on a computer-readable recording medium. **The computer-readable recording medium includes all types of recording devices in which data readable by a computer system is stored.** In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A diagnostic system comprising:
a first device configured to train a machine learning-based diagnostic model using training images; and
a second device configured to determine whether a diagnostic target is defective using the diagnostic model provided from the first device and an inference image of the diagnostic target,
wherein the second device determines whether the inference image is a target for retraining based on whether one or more predefined conditions are satisfied, and
wherein the first device stores the original of the inference image which has been determined by the second device to be a target for retraining, in a predefined storage space.

2. The diagnostic system of claim 1, wherein the first device compresses an inference image determined not to be a target for retraining according to a predefined image processing process and stores the compressed image of the inference image separately from the original of the inference image.

3. The diagnostic system of claim 1, wherein the first device includes a storage device that stores the inference image, and
wherein the storage device includes:
a first storage space that stores a first image, which is the original of the inference image; and
a second storage space that stores a second image, which is a converted image of the original, having a lower capacity or quality.

4. The diagnostic system of claim 3, wherein the first device retrains the diagnostic model using a plurality of first images stored in the first storage space as training data.

5. The diagnostic system of claim 3, wherein the first device reconstructs at least some of the second images stored in the second storage space according to a predefined image processing process and retrains the diagnostic model using the reconstructed images.

6. The diagnostic system of claim 3, wherein the first device converts a first image for which a preset storage period has elapsed, among a plurality of first images stored in the first storage space, into a second image and stores the second image in the second storage space.

7. The diagnostic system of claim 1, wherein the second device determines the inference image as a target for retraining if both conditions are satisfied, the conditions including:
a first condition, in which the inference image is determined to be defective by the diagnostic model; and
a second condition, in which the inference image is determined to be defective by a defect detection model defined separately from the diagnostic model.

8. The diagnostic system of claim 7, wherein the second device determines the inference image as a target for retraining if a third condition, in which an abnormal area is detected by an anomaly detection model defined separately from the diagnostic model and the defect detection model, is satisfied, even if the first condition is not satisfied.

9. An operation method of a diagnostic system including a first device configured to train a machine learning-based diagnostic model using training images; and a second device configured to determine whether a diagnostic target is defective using the diagnostic model provided from the first device and an inference image of the diagnostic target, the method comprising:
determining, by the second device, whether the inference image is a target for retraining based on whether one or more predefined conditions are satisfied; and
storing, by the first device, the original of the inference image which has been determined by the second device to be a target for retraining, in a predefined storage space.

10. The method of claim 9, further comprising:
compressing, by the first device, an inference image determined not to be a target for retraining according to a predefined image processing process; and
storing, by the first device, the compressed image of the inference image separately from the original of the inference image.

11. The method of claim 9, wherein the first device includes a storage device that stores the inference image, and
wherein the storage device includes:
a first storage space that stores a first image, which is the original of the inference image; and
a second storage space that stores a second image, which is a converted image of the original, having a lower capacity or quality.

12. The method of claim 11, further comprising:
retraining, by the first device, the diagnostic model using a plurality of first images stored in the first storage space as training data.

13. The method of claim 11, further comprising:
reconstructing, by the first device, at least some of the second images stored in the second storage space according to a predefined image processing process; and
retraining, by the first device, the diagnostic model using the reconstructed images.

14. The method of claim 11, further comprising:
converting, by the first device, a first image for which a preset storage period has elapsed, among a plurality of first images stored in the first storage space, into a second image and storing the second image in the second storage space.

15. The method of claim 9, wherein the determining of whether the inference image is a target for retraining includes:
determining the inference image as a target for retraining if both conditions are satisfied, the conditions including a first condition, in which the inference image is determined to be defective by the diagnostic model; and a second condition, in which the inference image is determined to be defective by a defect detection model defined separately from the diagnostic model.

16. The method of claim 15, wherein the determining of whether the inference image is a target for retraining includes:
determining the inference image as a target for retraining if a third condition, in which an abnormal area is detected by an anomaly detection model defined separately from the diagnostic model and the defect detection model, is satisfied, even if the first condition is not satisfied.
